# EUROPEAN PATENT APPLICATION

(11) **EP 4 715 474 A1**
(43) Date of publication of application: **25.03.2026**
(21) Application number: 25161005.1
(22) Date of filing: 28.02.2025
(51) Int. Cl.: G03G 15/04, G03G 15/00, G03G 21/16, B41J 2/45

(54) **LIGHT EXPOSURE DEVICE AND IMAGE FORMING APPARATUS**

(30) Priority: 20.09.2024 JP 2024164366
(71) Applicant: Fujifilm Business Innovation Corp., Tokyo 107-0052 (JP)
(72) Inventor: SUZUKI, Yoshiyuki, Yokohama (JP); KASUYA, Yosuke, Ebina (JP)
(74) Representative: Meissner Bolte Partnerschaft mbB

(57) **Abstract**

A light exposure device includes a light emitter (1) that outputs light, and that is supported to be movable relative to a body (U1) of an image forming apparatus (U); a wiring member (32) connected to the light emitter, and having an extra length to allow the wiring member to be folded back near one end of the wiring member in a movement direction of the light emitter while the light emitter is attached to the body of the image forming apparatus; and a separator (21, 33) disposed at a folded-back portion of the wiring member to separate portions of the folded-back portion of the wiring member from each other.

## Description

### Background

### (i) Technical Field

The present disclosure relates to a light exposure device and an image forming apparatus including a light exposure device.

### (ii) Related Art

Japanese Unexamined Patent Application Publication No. 2015-205497 ([0019] to [0025] and Fig. 5) describes a technology relating to a light exposure device in an electrophotographic image forming apparatus that performs light exposure to form a latent image.

Japanese Unexamined Patent Application Publication No. 2015-205497 describes an image forming apparatus (100) including a light exposure unit (52) removable by being slid from the front side of the image forming apparatus (100). A cable (502) of the light exposure unit (52) is housed while being bent in an area (D1). When the light exposure unit (52) is pulled out forward, the folded-back portion is stretched to reduce deformation of a light exposure portion (521).

### Summary

Accordingly, it is an object of the present disclosure to provide a light exposure device that includes a wiring member, which is stretched from the light emitter when the light exposure device moves and which includes a deformable folded-back portion. The light exposure device reduces noise caused by the wiring member further than a light exposure device not including a separating member that separates portions of the folded-back portion from each other.

According to a first aspect of the present disclosure, there is provided a light exposure device comprising
a light emitter that outputs light, and that is supported to be movable relative to a body of an image forming apparatus;
a wiring member connected to the light emitter, and having an extra length to allow the wiring member to be folded back near one end of the wiring member in a movement direction of the light emitter while the light emitter is attached to the body of the image forming apparatus; and
a separator disposed at a folded-back portion of the wiring member to separate portions of the folded-back portion of the wiring member from each other.

According to a second aspect of the present disclosure, there is provided a light exposure device dependent on the first aspect, comprising:
a supporter that supports the light emitter while allowing the light emitter to move, and that is fixed to a body of an image forming apparatus,
wherein the separator is disposed at the supporter, and
wherein the light exposure device further comprises a transit portion disposed between a surface of the supporter located closer to the light emitter and a rear surface of the separator opposite to a surface located closer to the light emitter to allow the wiring member to pass therethrough.

According to a third aspect of the present disclosure, there is provided a light exposure device dependent on the second aspect,
wherein the transit portion is misaligned with, in the movement direction, a widthwise middle of a connection terminal where the wiring member and the light emitter are connected.

According to a fourth aspect of the present disclosure, there is provided a light exposure device dependent on any one of the first to third aspects,
wherein the separator is located at a position, in the movement direction, corresponding to a position of a connection terminal of the wiring member located closer to the light emitter.

According to a fifth aspect of the present disclosure, there is provided a light exposure device dependent on any one of the first to fourth aspects,
wherein the separator is formed from a ferrite core that removes noise.

According to a sixth aspect of the present disclosure, there is provided a light exposure device dependent on any one of the first to fifth aspects, comprising:
a second separator disposed between the light emitter and the wiring member at the folded-back portion to separate the wiring member from the light emitter.

According to a seventh aspect of the present disclosure, there is provided a light exposure device dependent on the sixth aspect,
wherein the second separator is disposed at the light emitter to extend in the movement direction.

According to an eighth aspect of the present disclosure, there is provided a light exposure device dependent on the sixth or seventh aspect,
wherein the second separator is misaligned, in the movement direction, with a position of a connection terminal of the wiring member located nearer the light emitter.

According to a ninth aspect of the present disclosure, there is provided a light exposure device dependent on any one of the first to eighth aspects, comprising
a holding member that holds the wiring member extending from a connection terminal located at a position of the wiring member nearer the light emitter, the holding member extending in a direction crossing the movement direction.

According to a tenth aspect of the present disclosure, there is provided a light exposure device dependent on the ninth aspect,
wherein the wiring member is folded to change a direction in which the wiring member extends to the movement direction at a portion near an end portion of the holding member farther from the connection terminal.

According to an eleventh aspect of the present disclosure, there is provided a light exposure device dependent on the tenth aspect,
wherein the wiring member is folded along a width direction of the wiring member.

According to a twelfth aspect of the present disclosure, there is provided an image forming apparatus, comprising:
an image holding member;
the light exposure device according to any one of the first to the eleventh aspects that exposes the image holding member to light to form a latent image;
a developing member that develops the latent image on the image holding member;
a transfer member that transfers an image obtained with development performed by the developing member to a medium; and
a fixing member that fixes the image transferred to the medium.

According to the first and twelfth aspects, the light exposure device that includes the wiring member, which is stretched from the light emitter when the light exposure device moves and which includes the deformable folded-back portion, is capable of reducing noise caused by the wiring member further than a light exposure device not including a separating member that separate portions of the folded-back portion from each other.

According to the second aspect, a portion of the wiring member that has passed a transit portion is less likely to come into contact with another portion of the wiring member than in a structure not including a transit portion.

According to the third aspect, portions of the wiring member are less likely to come into contact with each other near the transit portion than in a structure where the transit portion is located at a position corresponding to the middle of a connection terminal in the width direction.

According to the fourth aspect, a portion of the wiring member stretched from the connection terminal is less likely to come into contact with another portion of the wiring member than in a structure where a separator is misaligned with the position of the connection terminal.

According to the fifth aspect, a noise caused by the wiring member is removed further than in a structure where a separator is not formed from a ferrite core, and thus, the transmission characteristics is improved.

According to the sixth aspect, the wiring member less frequently comes into contact with a light emitter than in a structure not including a second separator.

According to the seventh aspect, the second separator and the wiring member less frequently interfere with each other during movement of the light emitter than in a structure where the second separator is not disposed at the light emitter.

According to the eighth aspect, the second separator less frequently interferes with the wiring member stretched from the connection terminal than in a structure where the second separator is not misaligned with the position of the connection terminal.

According to the ninth aspect, the wiring member stretched from the connection terminal is less easily distorted than in a structure not including a holding member.

According to the tenth aspect, the wiring member is less easily distorted than in a structure where the wiring member is not foldable near an end portion of the holding member.

According to the eleventh aspect, the wiring member is more easily foldable than in a structure where the wiring member is not foldable along the width direction.

### Brief Description of the Drawings

Exemplary embodiments of the present disclosure will be described in detail based on the following figures, wherein:
Fig. 1 illustrates the entirety of an image forming apparatus according to a first example;
Fig. 2 is a diagram of a related portion of an image recording portion according to the first example;
Fig. 3 is a diagram of a frame body portion of an image forming apparatus including a light exposure device according to the first example;
Fig. 4 is a perspective view of a writing device according to the first example;
Figs. 5A to 5E are diagrams of portions of the writing device according to the first example, where Fig. 5A is a diagram of a guidable member, Fig. 5B is a diagram of the guidable member viewed in a direction of arrow VB in Fig. 5A, Fig. 5C is a perspective view of a light emission supporter, Fig. 5D is a diagram of the light emission supporter and the guidable member attached to each other, and Fig. 5E is a perspective view of a light emitter;
Fig. 6 is a diagram of a supporter on the body that supports the writing device;
Fig. 7 is a diagram of the supporter in Fig. 6 viewed from the bottom;
Fig. 8 is a cross-sectional view of the frame body portion taken along line VIII-VIII in Fig. 3;
Fig. 9 is a diagram of a related portion of a wire housing member according to the first example;
Fig. 10 is a partially enlarged diagram of the wiring member and a holding member according to the first example; and
Fig. 11 is a diagram of a modification example.

### Detailed Description

With reference now to the drawings, examples serving as specific examples of exemplary embodiments of the present disclosure are described, but the present disclosure is not limited to the examples described below.

For easy understanding of the description below, throughout the drawings, an X-axis direction denotes the front-rear direction, a Y-axis direction denotes the lateral direction, and a Z-axis direction denotes the vertical direction. The directions or sides indicated by arrows X, - X, Y, -Y, Z, and -Z are respectively referred to as forward, rearward, rightward, leftward, upward, and downward, or a front side, a rear side, a right side, a left side, an upper side, and a lower side.

Throughout the drawings, an encircled dot denotes an arrow directing from the back to the front of the sheet, and an encircled cross denotes an arrow directing from the front to the back of the sheet.

In the description with reference to the drawings, components other than those needed for the description are omitted as appropriate for ease of understanding.

### First Example

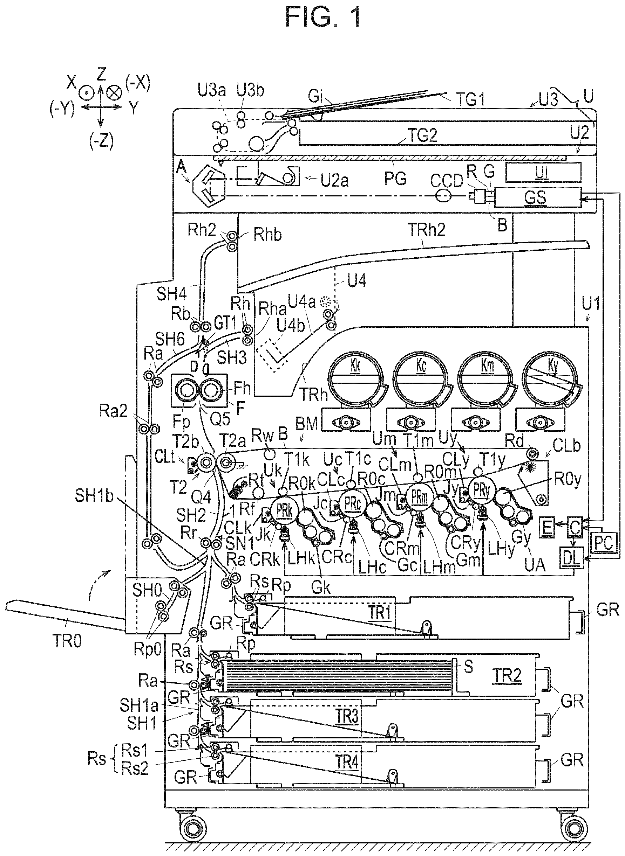

Fig. 1 illustrates the entirety of an image forming apparatus according to a first example.

In Fig. 1, a copying machine U serving as an example of the image forming apparatus according to the first example of the present disclosure includes a printer portion U1, serving as an example of an image recorder and an example of a body of the image forming apparatus. The printer portion U1 supports, at an upper portion, a scanner portion U2, serving as an example of a reading unit and an example of an image reading device. The scanner portion U2 supports, at an upper portion, an auto-feeder U3 serving as an example of a document transporting device.

At an upper portion of the auto-feeder U3, a document tray TG1, serving as an example of a medium container, is disposed. The document tray TG1 is capable of receiving a stack of multiple documents Gi that are to be copied. Below the document tray TG1, a document exit tray TG2 serving as an example of a document exit portion is disposed. Between the document tray TG1 and the document exit tray TG2, document transport rollers U3b are disposed along a document transport path U3a.

At the upper surface of the scanner portion U2, a platen glass PG serving as an example of a transparent document table is disposed. The scanner portion U2 according to the first example includes a reading unit U2a, which serves as an example of a reader and is disposed below the platen glass PG. The reading unit U2a according to the first example is supported to be movable in a lateral direction, serving as an example of a sub-scanning direction, along the lower surface of the platen glass PG. The reading unit U2a is electrically connected to an image processor GS.

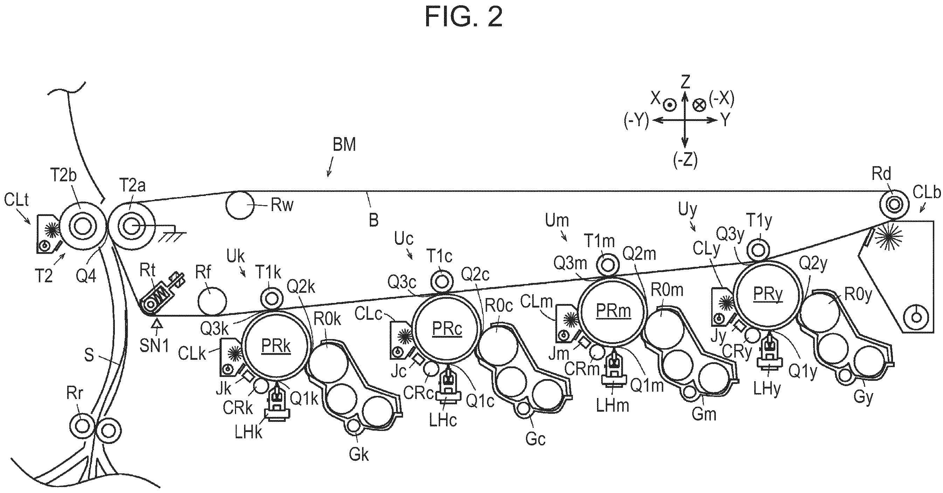

Fig. 2 is a diagram of a related portion of an image recording portion according to the first example.

The image processor GS is electrically connected to a write circuit DL in the printer portion U1. The write circuit DL is electrically connected to writing devices LHy, LHm, LHc, and LHk serving as examples of latent image forming devices.

The writing devices LHy to LHk according to the first example each include, for example, a light emitting diode (LED) head including multiple LEDs arranged in a main scanning direction. The writing devices LHy to LHk are capable of outputting write light beams corresponding to colors of yellow (Y), magenta (M), cyan (C), and black (K) in accordance with signals input from the write circuit DL.

The write circuit DL or a power source circuit E are controlled in terms of write timing or power supply timing in accordance with control signals from a controller C serving as an example of a control member.

In Fig. 1, above the writing devices LHy to LHk, photoconductors PRy, PRm, PRc, and PRk serving as examples of image carriers are disposed. In Fig. 1 and Fig. 2, the areas of the photoconductors PRy to PRk irradiated with write light constitute write areas Q1y, Q1m, Q1c, and Q1k.

Upstream from the write areas Q1y to Q1k in rotation directions of the photoconductors PRy to PRk, charging rollers CRy, CRm, CRc, and CRk serving as examples of chargers are respectively disposed. The charging rollers CRy to CRk according to the first example are supported to be rotatably driven while being in contact with the photoconductors PRy to PRk.

Downstream from the write areas Q1y to Q1k in the rotation directions of the photoconductors PRy to PRk, developing devices Gy, Gm, Gc, and Gk serving as examples of developing members are respectively disposed. Areas where the photoconductors PRy to PRk and the developing devices Gy to Gk respectively face one another constitute development areas Q2y, Q2m, Q2c, and Q2k.

Downstream from the developing devices Gy to Gk in the rotation directions of the photoconductors PRy to PRk, first transfer rollers T1y, T1m, T1c, and T1k serving as examples of first transfer members are respectively disposed. Areas where the photoconductors PRy to PRk and the first transfer rollers T1y to T1k respectively face one another constitute first transfer areas Q3y, Q3m, Q3c, and Q3k.

Downstream from the first transfer rollers T1y to T1k in the rotation directions of the photoconductors PRy to PRk, photoconductor cleaners CLy, CLm, CLc, and CLk serving as examples of cleaners are respectively disposed.

Downstream from the photoconductor cleaners CLy to CLk in the rotation directions of the photoconductors PRy to PRk, static eliminators Jy, Jm, Jc, and Jk serving as examples of static eliminating members or examples of static eliminating devices are respectively disposed.

The photoconductor PRy, the charging roller CRy, the writing device LHy, the developing device Gy, the first transfer roller T1y, the photoconductor cleaner CLy, and the static eliminator Jy for the color Y constitute an image forming portion Uy for the color Y serving as an example of a visible image forming member for the color Y according to the first example that forms toner images of the color Y. Similarly, each of the photoconductors PRm, PRc, and PRk, the corresponding one of the charging rollers CRm, CRc, and CRk, the corresponding one of the writing devices LHm, LHc, and LHk, the corresponding one of the developing devices Gm, Gc, and Gk, the corresponding one of the first transfer rollers T1m, T1c, and T1k, the corresponding one of the photoconductor cleaners CLm, CLc, and CLk, and the corresponding one of the static eliminators Jm, Jc, and Jk constitute an image forming portion Um, Uc, or Uk for the corresponding one of the colors M, C, and K.

Above the photoconductors PRy to PRk, a belt module BM serving as an example of an intermediate transfer device is disposed. The belt module BM includes an intermediate transfer belt B serving as an example of an image carrier and an example of an intermediate transfer member. The intermediate transfer belt B is formed from an endless belt.

The intermediate transfer belt B according to the first example is rotatably supported by a tension roller Rt serving as an example of a tensioner, a walking roller Rw serving as an example of an imbalance corrector, an idler roller Rf serving as an example of a driven member, a backup roller T2a serving as an example of an opposing member opposing a second transfer area, the first transfer rollers T1y to T1k, and a driving roller Rd serving as an example of a driving member. In the first example, when a driving force is transmitted to the driving roller Rd, the intermediate transfer belt B rotates.

At a position facing the backup roller T2a across the intermediate transfer belt B, a second transfer roller T2b serving as an example of a second transfer member is disposed. Components including the backup roller T2a and the second transfer roller T2b constitute a second transfer device T2 according to the first example serving as an example of a transfer device. The area where the second transfer roller T2b and the intermediate transfer belt B are in contact constitutes a second transfer area Q4.

Downstream from the second transfer area Q4 in the rotation direction of the intermediate transfer belt B, a belt cleaner CLb is disposed as an example of a cleaning device to clean the intermediate transfer body.

Components including the first transfer rollers T1y to T1k, the intermediate transfer belt B, and the second transfer device T2 constitute a transfer device T1+T2+B serving as an example of a transfer member according to the first example. The image forming portions Uy to Uk and the transfer device T1+T2+B constitute an image recording portion Uy-Uk+T1+T2+B according to the first example.

In Fig. 1, below the image forming portions Uy to Uk, four pairs of left and right guide rails GR serving as examples of guide members are disposed. On the guide rails GR, sheet feeding trays TR1, TR2, TR3, and TR4 serving as examples of medium containers are supported to be movable in and out in a front-rear direction. The sheet feeding trays TR1 to TR4 receive recording paper sheets S serving as examples of media.

At the upper left of each of the sheet feeding trays TR1 to TR4, a pickup roller Rp serving as an example of a pickup member is disposed. Downstream from the pickup roller Rp in the transport direction of the recording paper sheet S, separation rollers Rs serving as examples of separation members are disposed. Downstream from the separation rollers Rs in the transport direction of the recording paper sheet S, a sheet feeding path SH1 extending upward is disposed as an example of a medium transport path. Multiple transport rollers Ra serving as examples of transport members are disposed on the sheet feeding path SH1.

At a lower left of the copying machine U, a manual feed tray TR0 serving as an example of a medium container is disposed. At an upper right of the manual feed tray TR0, pickup rollers Rp0 are disposed, and a manual sheet feeding path SH0 extends. The manual sheet feeding path SH0 merges into the sheet feeding path SH1.

On the sheet feeding path SH1, upstream from the second transfer area Q4, registration rollers Rr serving as examples of adjusters of a transport timing are disposed. A transport path SH2 extends from the registration rollers Rr toward the second transfer area Q4.

Downstream from the second transfer area Q4 in the transport direction of the recording paper sheet S, a fixing device F serving as an example of a fixing member is disposed. The fixing device F includes a heating roller Fh serving as an example of a fixing member for heating, and a pressing roller Fp serving as an example of a fixing member for pressing. A contact area where the heating roller Fh and the pressing roller Fp are in contact constitutes a fixing area Q5.

At an upper surface of the printer portion U1, a lower paper exit tray TRh serving as an example of a medium exit portion is disposed. In the first example, at the lower paper exit tray TRh, a finisher U4 serving as an example of a postprocessing device is disposed. Above the fixing device F, a sheet exit path SH3 serving as an example of a transport path extends toward the lower paper exit tray TRh. At the downstream end of the sheet exit path SH3, discharging rollers Rh serving as examples of medium transporting members are disposed.

Above the lower paper exit tray TRh, an upper paper exit tray TRh2 serving as an example of a medium exit portion is disposed. Above the fixing device F, an upper transport path SH4 that diverges from the sheet exit path SH3 to extend toward the upper paper exit tray TRh2 is disposed.

On the upper transport path SH4, reverse rollers Rb serving as examples of medium transporting members rotatable forward and backward are disposed. Above a position where the sheet exit path SH3 and the upper transport path SH4 diverge, a reverse path SH6 serving as an example of a medium transport path diverges to the lower left from the upper transport path SH4.

A gate GT1 serving as an example of a switching member is disposed across a diverging portion at which the sheet exit path SH3 and the upper transport path SH4 diverge and a diverging portion at which the upper transport path SH4 and the reverse path SH6 diverge. The gate GT1 is supported to be switchable between a first guide position (a second position) to guide the recording paper sheet S from the fixing device F toward the lower paper exit tray TRh, and to guide the recording paper sheet S from the upper transport path SH4 to the reverse path SH6, and a second guide position (a first position) to guide the recording paper sheet S from the fixing device F toward the upper transport path SH4.

Multiple transport rollers Ra serving as examples of medium transport members are disposed on the reverse path SH6. The downstream end of the reverse path SH6 merges into the sheet feeding path SH1 upstream from the registration rollers Rr.

### Description of Image Forming Operation

When an operator manually places a document Gi on the platen glass PG to perform copying with the copying machine U according to the first example with the above structure, the reading unit U2a moves in the lateral direction from the initial position to scan the document Gi on the platen glass PG while exposing the document Gi with light. When the auto-feeder U3 is used to automatically transport documents Gi for photocopying, the multiple documents Gi received on the document tray TG1 are sequentially transported to and pass a document read position on the platen glass PG, and discharged to the document exit tray TG2. The documents Gi sequentially passing the read position on the platen glass PG are irradiated by the reading unit U2a with light to be scanned. Reflection light reflected off the documents Gi is received by the reading unit U2a. The reading unit U2a converts the received reflection light reflected off the documents Gi into electric signals. To perform both-side reading of the documents Gi, the documents Gi are also read by a reading sensor.

The image processor GS receives an input of electric signals output from the reading unit U2a. The image processor GS converts the electric signals of images of the colors R, G, and B read by the reading unit U2a into image information of yellow (Y), magenta (M), cyan (C), and black (K) for forming latent images. The image processor GS outputs the image information obtained after the conversion to the write circuit DL in the printer portion U1. To form a single-color image or a monochrome image as the image, the image processor GS outputs the image information of only black (K) to the write circuit DL.

The write circuit DL outputs control signals corresponding to the input image information to the writing devices LHy to LHk. The writing devices LHy to LHk output write light corresponding to the control signals.

Each of the photoconductors PRy to PRk is driven to rotate when the image formation is started. A charging voltage is applied to the charging rollers CRy to CRk from the power source circuit E. The surfaces of the photoconductors PRy to PRk are thus electrically charged by the charging rollers CRy to CRk. In the write areas Q1y to Q1k on the surfaces of the electrically charged photoconductors PRy to PRk, electrostatic latent images are formed by the writing devices LHy to LHk. The electrostatic latent images on the photoconductors PRy to PRk are developed into toner images, serving as examples of visible images, by the developing devices Gy to Gk in the development areas Q2y to Q2k.

The developed toner images are transported to the first transfer areas Q3y to Q3k at which the toner images come into contact with the intermediate transfer belt B, serving as an example of an intermediate transfer member. In the first transfer areas Q3y to Q3k, a first transfer voltage with a polarity opposite to the charging polarity of toner is applied from the power source circuit E to the first transfer rollers T1y to T1k. The toner images on the photoconductors PRy to PRk are thus transferred to the intermediate transfer belt B from the first transfer rollers T1y to T1k. To form a multi-color toner image, a toner image on the downstream side is transferred, in a superposed manner, onto a toner image that has been transferred to the intermediate transfer belt B in the upstream first transfer area.

Remnants or accretions on the photoconductors PRy to PRk that have undergone first transfer are removed by the photoconductor cleaners CLy to CLk. The surfaces of the cleaned photoconductors PRy to PRk undergo static elimination by the static eliminators Jy to Jk. The surfaces of the photoconductors PRy to PRk that have undergone static elimination are electrically charged again by the charging rollers CRy to CRk.

The single-color or multi-color toner image transferred onto the intermediate transfer belt B by the first transfer rollers T1y to T1k in the first transfer areas Q3y to Q3k is transported to the second transfer area Q4.

The recording paper sheet S on which an image is to be recorded is picked up by any of the pickup rollers Rp at the sheet feeding trays TR1 to TR4 to be used. When multiple recording paper sheets S are collectively picked up by the pickup roller Rp in a stacked manner, the multiple recording paper sheets S are separated one from another by the separation rollers Rs. The recording paper sheets S separated by the separation rollers Rs are transported by the transport rollers Ra along the sheet feeding path SH1. The recording paper sheets S transported along the sheet feeding path SH1 are transported to the registration rollers Rr. The recording paper sheets S loaded on the manual feed tray TR0 are also transported to the sheet feeding path SH1 through the manual sheet feeding path SH0 by the pickup rollers Rp0.

The registration rollers Rr transport the recording paper sheet S to the second transfer area Q4 at the timing when the toner image formed on the intermediate transfer belt B is transported to the second transfer area Q4. A second transfer voltage having a polarity opposite to the charging polarity of the toner is applied to the second transfer roller T2b by the power source circuit E. The toner image on the intermediate transfer belt B is thus transferred to the recording paper sheet S from the intermediate transfer belt B.

Accretions or other matter adhering to the surface of the intermediate transfer belt B that has undergone second transfer are removed by the belt cleaner CLb.

The recording paper sheet S to which the toner image is second transferred undergoes fixing with heat when passing the fixing area Q5.

When the recording paper sheet S to which an image is fixed is to undergo postprocessing, the recording paper sheet S is transported to the finisher U4, serving as an example of a postprocessing device, disposed at the lower paper exit tray TRh. When the recording paper sheet S is not to undergo postprocessing, the recording paper sheet S is transported to the upper paper exit tray TRh2. To transport the recording paper sheet S to the lower paper exit tray TRh, the gate GT1 moves to the first guide position. Thus, the recording paper sheet S fed from the fixing device F is transported along the sheet exit path SH3. The recording paper sheet S transported along the sheet exit path SH3 is transported by the discharging rollers Rh toward the finisher U4 and the lower paper exit tray TRh.

After performing a binding process, serving as an example of postprocessing, on the recording paper sheet S, the finisher U4 discharges the recording paper sheet S to the lower paper exit tray TRh.

To discharge the recording paper sheet S to the upper paper exit tray TRh2, the gate GT1 moves to the second guide position to discharge the recording paper sheet S to the upper paper exit tray TRh2.

To perform two-side printing on the recording paper sheet S, the gate GT1 moves to the second guide position. When the trailing end of the recording paper sheet S passes the gate GT1, the gate GT1 moves to the first guide position, and the reverse roller Rb rotates in the reverse direction. Thus, the recording paper sheet S is guided by the gate GT1 to be transported to the reverse path SH6. The recording paper sheet S transported along the reverse path SH6 is transported to the registration rollers Rr while being turned upside down.

### Description of Writing Devices LHy to LHk

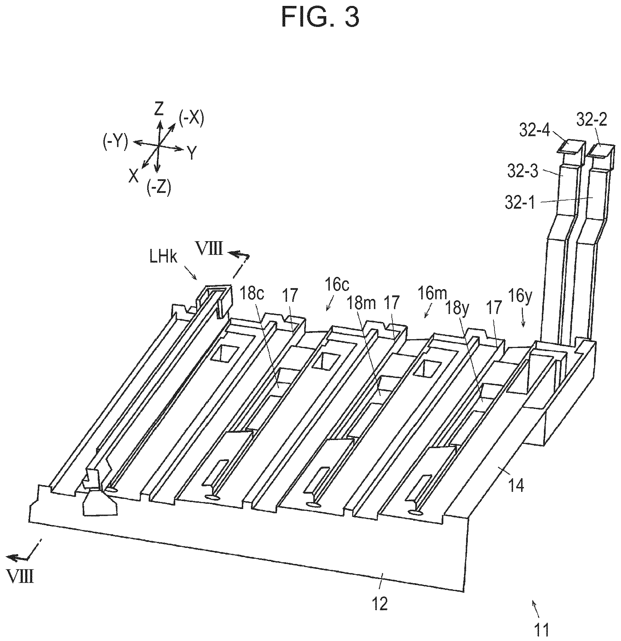

Fig. 3 is a diagram of a frame body portion of the image forming apparatus including a light exposure device according to the first example.

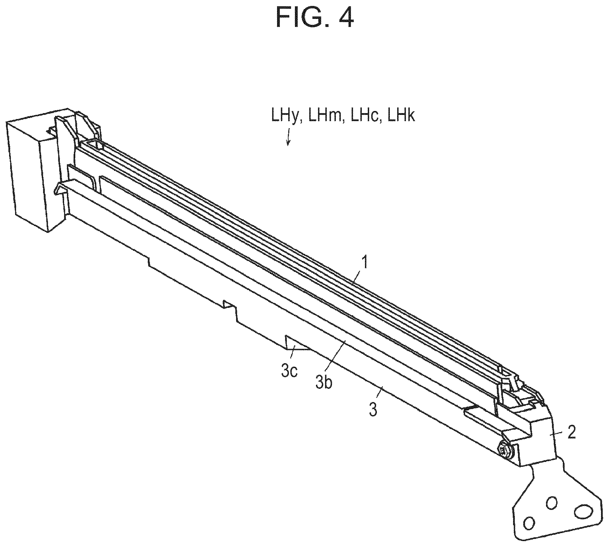

Fig. 4 is a perspective view of the writing device according to the first example.

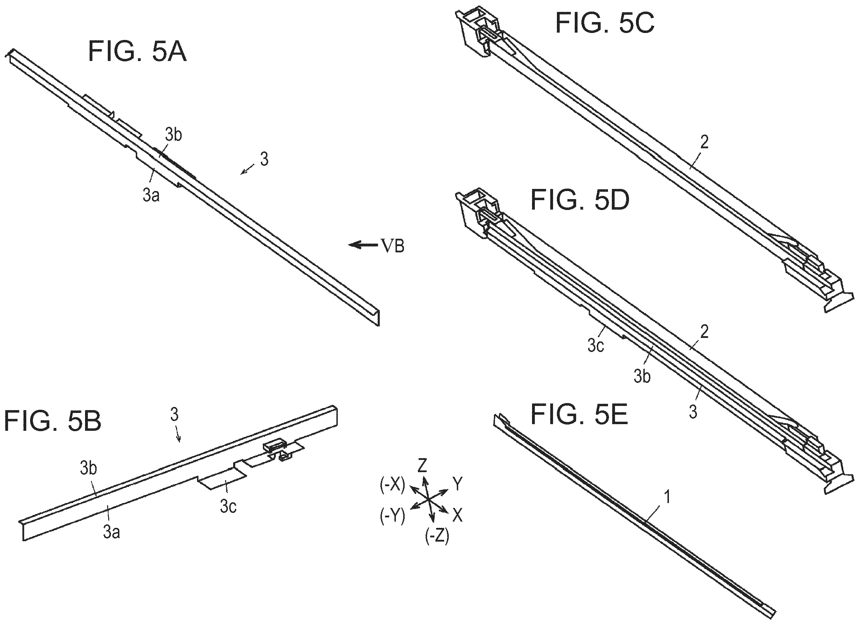

Figs. 5A to 5E are diagrams of portions of the writing device according to the first example, where Fig. 5A is a diagram of a guidable member, Fig. 5B is a diagram of the guidable member viewed in a direction of arrow VB in Fig. 5A, Fig. 5C is a perspective view of a light emission supporter, Fig. 5D is a diagram of the light emission supporter and the guidable member attached to each other, and Fig. 5E is a perspective view of a light emitter.

Fig. 3 illustrates the copying machine U according to the first example in which the writing devices LHy to LHk are supported by a marking guide 11 serving as an example of a supporter on the body. In Fig. 3, only the writing device LHk for the color K is attached, and the other writing devices LHy to LHc are removed.

In the following description, the writing devices LHy to LHk for different colors have the same structure, and y, m, c, and k in the reference signs may thus be omitted.

In Fig. 3 to Fig. 5E, the writing devices LHy to LHk each include a light-emitting-diode print head (LPH) body 1 serving as an example of a light emitter. The LPH body 1 has a rod shape extending in the front-rear direction. LED devices are arranged on the LPH body 1 in a line in the front-rear direction. A lens serving as an example of an optical member is disposed on the upper surface of the LPH body 1.

The LPH body 1 is supported by an LPH holder 2 serving as an example of a light emission supporter. The LPH holder 2 extends in the front-rear direction. The LPH holder 2 has the shape of a hollow angular prism, with left and right side walls, a bottom wall, and an open top. The left and right side walls and the bottom wall of the LPH holder 2 have openings, not illustrated, as appropriate to allow components such as wires or sensors to extend therethrough for installation.

An LPH guide 3 serving as an example of a guidable member is supported on the left side surface of the LPH holder 2. The LPH guide 3 has a plate shape extending in the front-rear direction. The LPH guide 3 has a plate portion 3a extending in the vertical direction. A rail portion 3b extends outward to the left from an upper portion of the plate portion 3a.

At the lower end of the plate portion 3a and at a middle portion in the front-rear direction, a second separator plate 3c serving as an example of a second separator is disposed. The second separator plate 3c has a plate shape extending in the front-rear direction and a lateral direction. The second separator plate 3c is disposed below the bottom wall of the LPH holder 2.

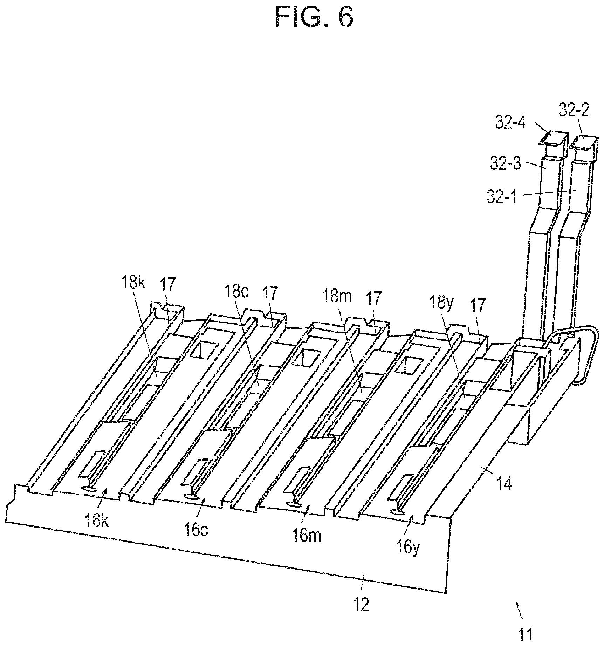

Fig. 6 is a diagram of a supporter on the body that supports the writing device.

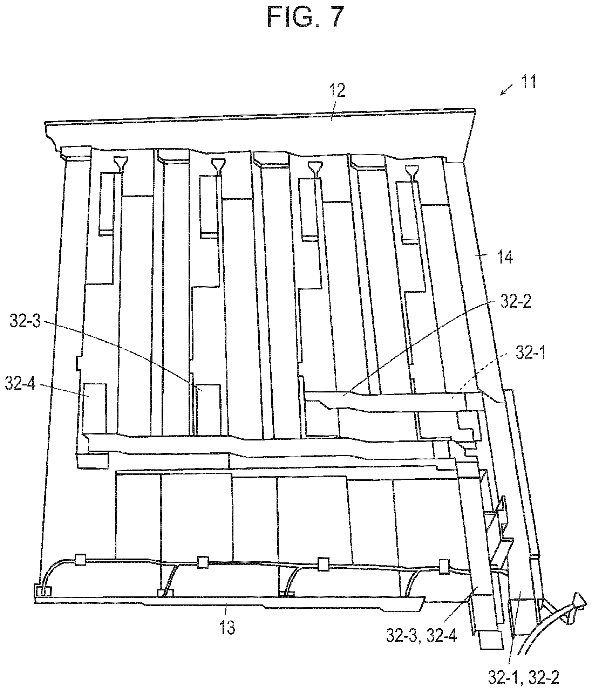

Fig. 7 is a diagram of the supporter in Fig. 6 viewed from the bottom.

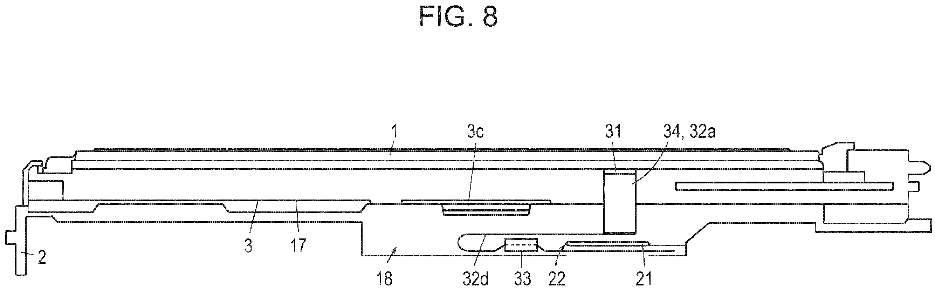

Fig. 8 is a cross-sectional view of the frame body portion taken along line VIII-VIII in Fig. 3.

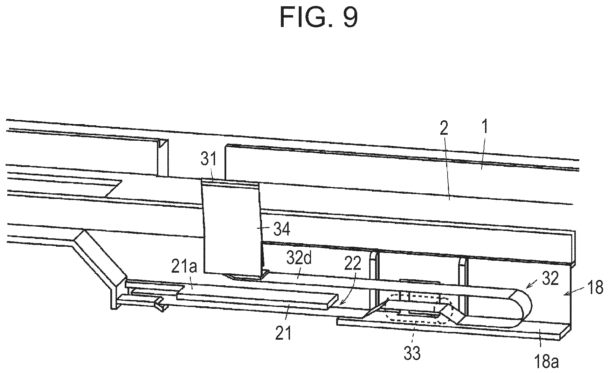

Fig. 9 is a diagram of a related portion of a wire housing member according to the first example.

In Fig. 3 and Fig. 6, the marking guide 11 includes a front plate portion 12, a rear plate portion 13, and a guide body 14 serving as an example of a support body portion.

The guide body 14 includes four guide portions 16y, 16m, 16c, and 16k corresponding to the four writing devices LHy to LHk.

In the following description, the guide portions 16y, 16m, 16c, and 16k have the same structure, and y, m, c, and k in the reference signs may thus be omitted.

Each guide portion 16 extends in the front-rear direction along the corresponding one of the writing devices LHy to LHk. A guide rail 17 serving as an example of a guide member is disposed on the left of each guide portion 16. The guide rail 17 supports the LPH guide 3 while allowing the LPH guide 3 to move in the front-rear direction. Thus, the writing devices LHy to LHk are supported by the marking guide 11 to be movable in the front-rear direction. For maintenance such as inspection or replacement of the writing devices LHy to LHk, each of the writing devices LHy to LHk is individually insertable into or extractable from, or attachable to and removable from the copying machine U in the front-rear direction.

In Fig. 6, Fig. 8, and Fig. 9, a cable housing portion 18 serving as an example of a wire housing member is formed at a middle portion of the guide portion 16 in the front-rear direction. The cable housing portion 18 is recessed downward.

A raised bottom plate 21 serving as an example of a separator is supported at the bottom portion of the cable housing portion 18. The raised bottom plate 21 is disposed above a bottom surface 18a of the cable housing portion 18, that is, disposed closer to the corresponding one of the writing devices LHy to LHk. The raised bottom plate 21 has a plate shape. A wire port 22 serving as an example of a wire transit portion is formed below the raised bottom plate 21. The wire port 22 is thus formed between the bottom surface 18a and a rear surface of the raised bottom plate 21, opposite to the top surface or a surface 21a facing the corresponding one of the writing devices LHy to LHk.

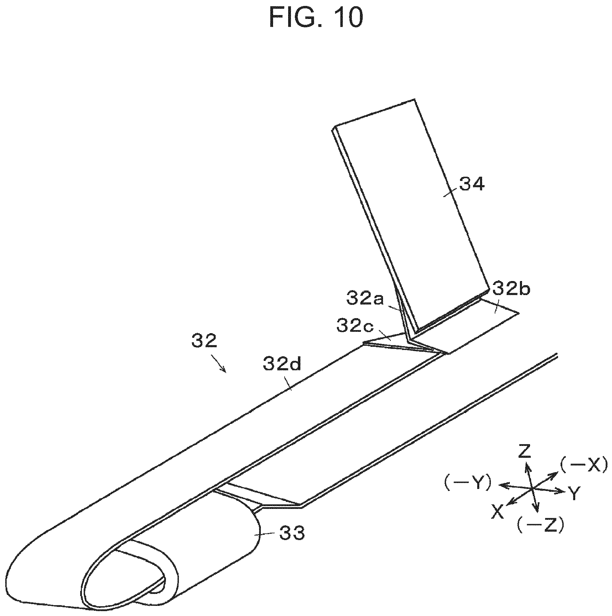

Fig. 10 is an enlarged diagram of the wiring member and a holding member according to the first example.

In Fig. 8 and Fig. 9, the writing devices LHy to LHk according to the first example each includes a connector 31 serving as an example of a connection terminal disposed below the LPH body 1. The connector 31 is located at a position corresponding to the cable housing portion 18 while the corresponding one of the writing devices LHy to LHk is attached to the marking guide 11.

A flexible flat cable (FFC) 32 serving as an example of a wiring member is connected to the connector 31. The FFC 32 has a wide and flat cross section. The FFC 32 supplies power to the LPH body 1 or transmits and receives control signals. In Fig. 10, the FFC 32 has an upper end portion 32a extending downward from the connector 31. In the upper end portion 32a, the width of the flat shape is in the front-rear direction.

A first folded portion 32b is connected to the lower end of the upper end portion 32a. The first folded portion 32b is formed by being folded rightward.

A second folded portion 32c is connected to the right end of the first folded portion 32b. The second folded portion 32c is formed by being folded leftward. Thus, the second folded portion 32c is formed by being folded by 180° in the opposite direction to the first folded portion 32b. The first folded portion 32b and the second folded portion 32c thus overlap to form two layers.

A third folded portion 32d is connected to a left portion of the second folded portion 32c. The third folded portion 32d is formed by being folded, relative to the second folded portion 32c, by an angle inclined with respect to the front-rear direction and the lateral direction. The third folded portion 32d is thus folded along the width direction to extend forward. In other words, the direction in which the third folded portion 32d extends is changed by 90° relative to the second folded portion 32c. After the third folded portion 32d is formed by being folded, the width direction of the flat shape is changed from the front-rear direction to the lateral direction.

In Fig. 8 and Fig. 9, when reaching the front portion of the cable housing portion 18, the third folded portion 32d is bent rearward. More specifically, the front portion of the third folded portion 32d is bent rearward with a curve protruding forward. Thus, the entirety of the FFC 32 has an extra length that is bent at a front portion, or a portion near one end in the movement direction of the corresponding one of the writing devices LHy to LHk when the corresponding one of the writing devices LHy to LHk is attached to the body of the copying machine U.

The rear end of the folded portion of the third folded portion 32d passes through the wire port 22. A ferrite core 33 serving as an example of a separator is attached to the third folded portion 32d at a portion in front of the wire port 22. Thus, the FFC 32 according to the first example extends through the ferrite core 33. The ferrite core 33 reduces or eliminates noise caused when electricity or a control signal passes through the FFC 32.

In Fig. 7, a portion of the FFC 32 that has passed the wire port 22 is guided to below the lower surface of the marking guide 11. The FFCs 32-1 and 32-2 for the color Y and the color M are folded rightward after passing through the corresponding wire ports 22. After reaching the right end of the marking guide 11, the FFCs 32-1 and 32-2 for the color Y and the color M are folded rearward. The rear end portions of the FFCs 32-1 and 32-2 extend toward the controller C on the body of the copying machine U.

The FFCs 32-3 and 32-4 for the color C and the color K extend rearward after passing through the corresponding wire ports 22 and are then folded rightward. After reaching the right end portion of the marking guide 11, the FFCs 32-3 and 32-4 for the color C and the color K are folded rearward. The rear end portions of the FFCs 32-3 and 32-4 extend toward the controller C on the body of the copying machine U.

In Fig. 10, a holding film 34 serving as an example of a holding member is disposed along the upper end portion 32a of the FFC 32. The holding film 34 has an upper end supported near the connector 31. The holding film 34 has a film shape extending in the vertical direction along the upper end portion 32a. More specifically, the holding film 34 extends in the vertical direction crossing the front-rear direction or the movement direction of the corresponding one of the writing devices LHy to LHk. In the first example, the holding film 34 has a length set to allow the lower end of the holding film 34 to be aligned with the lower end of the upper end portion 32a. Thus, a portion of the FFC 32 according to the first example near the lower end portion of the holding film 34 opposite to the end portion nearer the connector 31 is folded at an edge of the third folded portion 32d, so that the direction in which the FFC 32 extends is changed to the front-rear direction.

Components including the LPH body 1, the LPH holder 2, the LPH guide 3, the marking guide 11, the connector 31, the FFC 32, the ferrite core 33, and the holding film 34 constitute each light exposure device (light exposure unit) according to the first example.

### Description of Positional Relationship between Components

In the first example, the raised bottom plate 21 is located at a position corresponding to the third folded portion 32d, serving as a folded-back portion of the FFC 32. Thus, the raised bottom plate 21 extends through a space between the first folded portion 32b or the second folded portion 32c disposed below the connector 31, and a lower bent-back portion of the third folded portion 32d.

In the first example, the raised bottom plate 21 has a dimension in the front-rear direction greater than the width of the connector 31 and the width of the upper end portion 32a. The entrance of the wire port 22 is thus misaligned with the middle of, for example, the connector 31 in the width direction. Thus, the wire port 22 is located at a position not overlapping the positions of the first folded portion 32b or the second folded portion 32c disposed below the connector 31.

The raised bottom plate 21 according to the first example is disposed below the connector 31 while the corresponding one of the writing devices LHy to LHk is attached to the marking guide 11. More specifically, the raised bottom plate 21 is located at a position corresponding to the position of the connector 31 in the front-rear direction or the movement direction of the corresponding one of the writing devices LHy to LHk.

The second separator plate 3c according to the first example is disposed above the third folded portion 32d to face the third folded portion 32d. Thus, the second separator plate 3c is disposed between the third folded portion 32d and the LPH body 1 or the LPH holder 2. The second separator plate 3c extends in the front-rear direction or the direction in which the third folded portion 32d extends. The second separator plate 3c is misaligned or located frontward from the position of the connector 31 in the front-rear direction.

### Operations of First Example

In the copying machine U according to the first example with the above structure, when each of the writing devices LHy to LHk is attached to the marking guide 11 in the copying machine U, the FFC 32 is housed with an extra length. When each of the writing devices LHy to LHk is attached or removed, the FFC 32 changes its position between a bent position and a stretched position. During the attachment or removal involving the change of its position, the FFC 32 may be bent to have a curve greater than intended, may be buckled, or may be deformed into an accordion shape. In other words, the FFC 32 may take a position or a bent state different from the set position or state. When the FFC 32 has an unintended bent state, portions of the third folded portion 32d of the FFC 32 may come into contact with each other, or the third folded portion 32d may come into contact with, for example, the LPH body 1. When portions of the third folded portion 32d come into contact with each other, noise may occur in electric signals flowing through the FFC 32. Particularly, the third folded portion 32d serving as a folded-back portion of the FFC 32 is housed in the cable housing portion 18 inside the copying machine U. Thus, after each of the writing devices LHy to LHk is attached, an operator is almost incapable of visually inspecting the state of the folded-back portion. Thus, the operator is almost incapable of checking whether the FFC 32 is in the set position in every operation.

With the technology described in Japanese Unexamined Patent Application Publication No. 2015-205497 in which no measure is taken to check whether the FFC 32 is in the set position, noise may occur at the folded-back portion of the FFC 32. Thus, the transmission characteristics of signals may also be lowered.

In contrast, in the first example, the raised bottom plate 21 extends through a space between the first folded portion 32b or the second folded portion 32c and the lower bent-back portion of the third folded portion 32d. The positions of the first folded portion 32b and the second folded portion 32c in the height direction are stable, and the lower bent-back portion is more likely to come into contact with the first folded portion 32b and the second folded portion 32c when protrude upward. In contrast, in the first example, the raised bottom plate 21 blocks portions of the FFC 32 from coming into contact with each other.

Particularly, in the first example, the raised bottom plate 21 is located at a position corresponding to the position of the connector 31. This structure is more likely to reduce contacts between portions of the FFC 32 with each other than in a structure where the position of the raised bottom plate 21 is misaligned with the position of the connector 31. The raised bottom plate 21 is preferably located at a position corresponding to the connector 31, but may be misaligned. The raised bottom plate 21 with a plate shape is described above as an example, but the present disclosure is not limited to this. The raised bottom plate 21 may have a shorter dimension in the front-rear direction and have a hook shape. Although a single raised bottom plate 21 is described above as an example, two or more raised bottom plates 21 may be included.

In the first example, the lower bent-back portion of the third folded portion 32d is guided toward below the lower surface of the marking guide 11 through the wire port 22. Thus, contacts between a portion of the FFC 32 below the raised bottom plate 21 and another portion of the FFC 32 are reliably reduced.

In the first example, the wire port 22 is misaligned or located frontward from the connector 31. In this structure, a portion of the FFC 32 near the wire port 22 protruding upward is less likely to come into contact a portion of the FFC 32 below the connector 31. Although preferably misaligned with the connector 31, the wire port 22 may be located below the connector 31.

In the first example, the ferrite core 33 is attached to the FFC 32 at a portion in front of the raised bottom plate 21. The ferrite core 33 removes or eliminates noise. The ferrite core 33 blocks contacts between an upper portion of the FFC 32 and a lower portion of the FFC 32 near the ferrite core 33. Thus, the contacts between portions of the FFC 32 are also reduced near the ferrite core 33.

In the first example, the second separator plate 3c is disposed below the LPH body 1 or the LPH holder 2. Thus, the second separator plate 3c restricts upward protrusion of the FFC 32 inside the cable housing portion 18. Contacts between the LPH body 1 or the LPH holder 2 with the FFC 32 are thus reduced. The second separator plate 3c is formed from an insulating material or has a surface to which an insulating coating is applied. Thus, the second separator plate 3c reduces noise caused by the FFC 32 coming into contact with the LPH holder 2 formed from a metal plate.

Particularly, the second separator plate 3c according to the first example is included in the LPH guide 3. Thus, when the LPH body 1 moves in the front-rear direction, the second separator plate 3c also moves. In a structure where the second separator plate 3c does not move, the upper end portion 32a of the FFC 32 that moves forward and rearward may interfere with the immobile second separator plate 3c. In contrast, in the first example, when the LPH body 1 moves in the front-rear direction, the second separator plate 3c also moves integrally, and thus the second separator plate 3c does not interfere with the upper end portion 32a of the FFC 32.

The second separator plate 3c according to the first example is misaligned with the position of the connector 31. Thus, the second separator plate 3c is less likely to interfere with the upper end portion 32a of the FFC 32 extending from the connector 31 than in a structure where the second separator plate 3c is located immediately below or near the connector 31.

In the first example, the holding film 34 is disposed along the upper end portion 32a. In a structure not including the holding film 34, the upper end portion 32a may be deformed to be twisted by receiving a force in the front-rear direction during front-rear movement of the LPH body 1. In contrast, in the first example, the upper end portion 32a that may be deformed to be twisted comes into contact with the holding film 34, and is stopped being deformed. Thus, the FFC 32 is less likely to be deformed in an unintended manner to be in a position different from the set position. In addition, contacts between portions of the FFC 32 are reduced.

Particularly, in the first example, the boundary between the lower end of the upper end portion 32a and the first folded portion 32b is located near the lower end portion of the holding film 34. Thus, the vertical dimension of the holding film 34 corresponds to the vertical dimension of the upper end portion 32a. When the holding film 34 is shorter than the upper end portion 32a, the upper end portion 32a may be twisted at a portion at which the holding film 34 is not disposed. In contrast, in the first example, the holding film 34 is disposed throughout in the vertical direction of the upper end portion 32a, and twisting of the upper end portion 32a is thus reduced.

The length of the holding film 34 is preferably the same as the length of the upper end portion 32a, but may be shorter than the length of the upper end portion 32a. Although the holding film 34 is preferably provided, the holding film 34 may be eliminated in, for example, a structure where the upper end portion 32a is sufficiently short or sufficiently thick to have no concern about being twisted.

In the first example, the FFC 32 is folded to form the first folded portion 32b and the second folded portion 32c, and is then folded to form the third folded portion 32d. If the FFC 32 is to be folded to form the third folded portion 32d directly from the upper end portion 32a or the first folded portion 32b, the folded portion tries to spread out due to its elastic restoring force, and is less likely to fix its shape. In contrast, in the first example, the FFC 32 is folded to form the first folded portion 32b and the second folded portion 32c, and is then folded to form the third folded portion 32d that is more likely to have a fixed shape. In addition, the first folded portion 32b and the second folded portion 32c overlap to form two layers, and thus the FFC 32 also maintains strength. Thus, the first folded portion 32b and the second folded portion 32c are less likely to be deformed into unintended shapes with a force exerted on the FFC 32 during front-rear movement of the LPH body 1. This structure thus reduces contacts between portions of the FFC 32. In addition, in the first example, the FFC 32 is folded to form the third folded portion 32d to have its width changed from the front-rear direction to the lateral direction. When the FFC 32 has its width in the front-rear direction, the FFC 32 is less likely to have a folded-back portion with an extra length. However, the first example in which the FFC 32 is folded to have its width changed into a different direction is allowed to have a folded-back portion.

Folding of the FFC 32 is not limited to the case described in the first example, but the FFC 32 may be folded more times. Alternatively, when the FFC 32 is formed from a material that easily retains its shape, the FFC 32 may be folded less.

### Modification Examples

Although an exemplary embodiment of the present disclosure has been described in detail above, the present disclosure is not limited to the above example, and may be modified in various manners within the scope of the gist of the present disclosure described in the scope of claims. Modification examples (H01) to (H05) of the present disclosure are described below.

(H01) As the image forming apparatus according to the above example, a copying machine U has been described, but the present disclosure is not limited to this. For example, the image forming apparatus may be formed from a printer, a fax machine, or a multifunction machine having multiple or all the functions of these. Instead of an electrophotographic image forming apparatus, the image forming apparatus is applicable to any image forming apparatus such as an inkjet or thermal transfer image forming apparatus.

(H02) The apparatus according to the above example employing four-color developers is described as an example of the copying machine U, but the present disclosure is not limited to this. For example, the copying machine U is also applicable to a single-color image forming apparatus or a multi-color image forming apparatus using three or less colors or five or more colors. Accordingly, the writing device is also applicable to a single writing device, or three or less or five or more writing devices.
(H03) In the above example, the endless intermediate transfer belt B is described as an example of an image carrier, but the present disclosure is not limited to this. For example, the image carrier may be a cylindrical intermediate transfer drum, a photoconductor drum, or a photoconductor belt. Instead, the present disclosure is also applicable to a structure that includes no intermediate transfer body and that directly records an image from a photoconductor to a recording paper sheet S.

(H04) In the above example, the writing devices LHy to LHk attachable to and removable from the image forming apparatus and connected to the image forming apparatus with a wire are described as examples, but the present disclosure is not limited to this. The present disclosure is also applicable to any units attachable to and removable from the image forming apparatus and connected to the image forming apparatus with a wire.

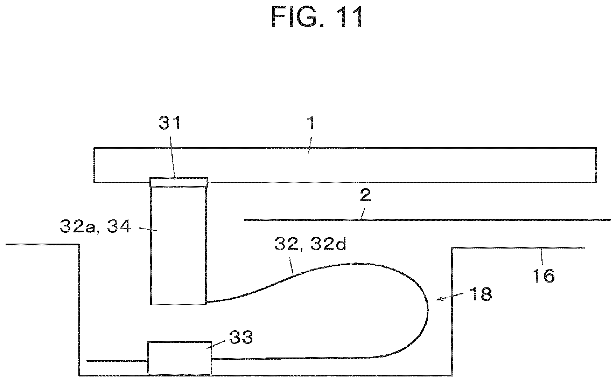

Fig. 11 is a diagram of a modification example.
(H05) In the above example, both the raised bottom plate 21 and the ferrite core 33 are provided as examples of separators, but the present disclosure is not limited to this. For example, the ferrite core 33 may be eliminated. In another example, depending on, for example, the position or the bendability of the FFC 32 or the length of the FFC 32, only the ferrite core 33 may be provided without providing the raised bottom plate 21. In another example, the ferrite core 33 may be disposed in place of the raised bottom plate 21, as illustrated in Fig. 11.

The foregoing description of the exemplary embodiments of the present disclosure has been provided for the purposes of illustration and description. It is not intended to be exhaustive or to limit the disclosure to the precise forms disclosed. Obviously, many modifications and variations will be apparent to practitioners skilled in the art. The embodiments were chosen and described in order to best explain the principles of the disclosure and its practical applications, thereby enabling others skilled in the art to understand the disclosure for various embodiments and with the various modifications as are suited to the particular use contemplated. It is intended that the scope of the disclosure be defined by the following claims and their equivalents.

### Appendix

(((1))) A light exposure device, comprising:
   a light emitter that outputs light, and that is supported to be movable relative to a body of an image forming apparatus;
   a wiring member connected to the light emitter, and having an extra length to allow the wiring member to be folded back near one end of the wiring member in a movement direction of the light emitter while the light emitter is attached to the body of the image forming apparatus; and
   a separator disposed at a folded-back portion of the wiring member to separate portions of the folded-back portion of the wiring member from each other.
(((2))) The light exposure device according to (((1))), comprising:
   a supporter that supports the light emitter while allowing the light emitter to move, and that is fixed to a body of an image forming apparatus,
   wherein the separator is disposed at the supporter, and
   wherein the light exposure device further comprises a transit portion disposed between a surface of the supporter located closer to the light emitter and a rear surface of the separator opposite to a surface located closer to the light emitter to allow the wiring member to pass therethrough.
(((3))) The light exposure device according to (((2))),
   wherein the transit portion is misaligned with, in the movement direction, a widthwise middle of a connection terminal where the wiring member and the light emitter are connected.
(((4))) The light exposure device according to any one of (((1))) to (((3))),
   wherein the separator is located at a position, in the movement direction, corresponding to a position of a connection terminal of the wiring member located closer to the light emitter.
(((5))) The light exposure device according to any one of (((1))) to (((4))),
   wherein the separator is formed from a ferrite core that removes noise.
(((6))) The light exposure device according to any one of (((1))) to (((5))), comprising:
   a second separator disposed between the light emitter and the wiring member at the folded-back portion to separate the wiring member from the light emitter.
(((7))) The light exposure device according to (((6))),
   wherein the second separator is disposed at the light emitter to extend in the movement direction.
(((8))) The light exposure device according to (((6))) or (((7))),
   wherein the second separator is misaligned, in the movement direction, with a position of a connection terminal of the wiring member located nearer the light emitter.
(((9))) The light exposure device according to any one of (((1))) to (((8))), comprising:
   a holding member that holds the wiring member extending from a connection terminal located at a position of the wiring member nearer the light emitter, the holding member extending in a direction crossing the movement direction.
(((10))) The light exposure device according to (((9))),
   wherein the wiring member is folded to change a direction in which the wiring member extends to the movement direction at a portion near an end portion of the holding member farther from the connection terminal.
(((11))) The light exposure device according to (((10))),
   wherein the wiring member is folded along a width direction of the wiring member.
(((12))) An image forming apparatus, comprising:
   an image holding member;
   the light exposure device according to any one of (((1))) to (((11))) that exposes the image holding member to light to form a latent image;
   a developing member that develops the latent image on the image holding member;
   a transfer member that transfers an image obtained with development performed by the developing member to a medium; and
   a fixing member that fixes the image transferred to the medium.

According to (((1))), the light exposure device that includes the wiring member, which is stretched from the light emitter when the light exposure device moves and which includes the deformable folded-back portion, is capable of reducing noise caused by the wiring member further than a light exposure device not including a separating member that separate portions of the folded-back portion from each other.

According to (((2))), a portion of the wiring member that has passed a transit portion is less likely to come into contact with another portion of the wiring member than in a structure not including a transit portion.

According to (((3))), portions of the wiring member are less likely to come into contact with each other near the transit portion than in a structure where the transit portion is located at a position corresponding to the middle of a connection terminal in the width direction.

According to (((4))), a portion of the wiring member stretched from the connection terminal is less likely to come into contact with another portion of the wiring member than in a structure where a separator is misaligned with the position of the connection terminal.

According to (((5))), a noise caused by the wiring member is removed further than in a structure where a separator is not formed from a ferrite core, and thus, the transmission characteristics is improved.

According to (((6))), the wiring member less frequently comes into contact with a light emitter than in a structure not including a second separator.

According to (((7))), the second separator and the wiring member less frequently interfere with each other during movement of the light emitter than in a structure where the second separator is not disposed at the light emitter.

According to (((8))), the second separator less frequently interferes with the wiring member stretched from the connection terminal than in a structure where the second separator is not misaligned with the position of the connection terminal.

According to (((9))), the wiring member stretched from the connection terminal is less easily distorted than in a structure not including a holding member.

According to (((10))), the wiring member is less easily distorted than in a structure where the wiring member is not foldable near an end portion of the holding member.

According to (((11))), the wiring member is more easily foldable than in a structure where the wiring member is not foldable along the width direction.

According to (((12))), the light exposure device that includes the wiring member, which is stretched from the light emitter when the light exposure device moves and which includes the deformable folded-back portion, is capable of reducing noise caused by the wiring member further than a light exposure device not including a separating member that separate portions of the folded-back portion from each other.

## Claims

1. A light exposure device, comprising:
a light emitter that outputs light, and that is supported to be movable relative to a body of an image forming apparatus;
a wiring member connected to the light emitter, and having an extra length to allow the wiring member to be folded back near one end of the wiring member in a movement direction of the light emitter while the light emitter is attached to the body of the image forming apparatus; and
a separator disposed at a folded-back portion of the wiring member to separate portions of the folded-back portion of the wiring member from each other.

2. The light exposure device according to claim 1, comprising:
a supporter that supports the light emitter while allowing the light emitter to move, and that is fixed to a body of an image forming apparatus,
wherein the separator is disposed at the supporter, and
wherein the light exposure device further comprises a transit portion disposed between a surface of the supporter located closer to the light emitter and a rear surface of the separator opposite to a surface located closer to the light emitter to allow the wiring member to pass therethrough.

3. The light exposure device according to claim 2,
wherein the transit portion is misaligned with, in the movement direction, a widthwise middle of a connection terminal where the wiring member and the light emitter are connected.

4. The light exposure device according to any one of claims 1 to 3,
wherein the separator is located at a position, in the movement direction, corresponding to a position of a connection terminal of the wiring member located closer to the light emitter.

5. The light exposure device according to any one of claims 1 to 4,
wherein the separator is formed from a ferrite core that removes noise.

6. The light exposure device according to any one of claims 1 to 5, comprising:
a second separator disposed between the light emitter and the wiring member at the folded-back portion to separate the wiring member from the light emitter.

7. The light exposure device according to claim 6,
wherein the second separator is disposed at the light emitter to extend in the movement direction.

8. The light exposure device according to claim 6 or 7,
wherein the second separator is misaligned, in the movement direction, with a position of a connection terminal of the wiring member located nearer the light emitter.

9. The light exposure device according to any one of claims 1 to 8, comprising:
a holding member that holds the wiring member extending from a connection terminal located at a position of the wiring member nearer the light emitter, the holding member extending in a direction crossing the movement direction.

10. The light exposure device according to claim 9,
wherein the wiring member is folded to change a direction in which the wiring member extends to the movement direction at a portion near an end portion of the holding member farther from the connection terminal.

11. The light exposure device according to claim 10,
wherein the wiring member is folded along a width direction of the wiring member.

12. An image forming apparatus, comprising:
an image holding member;
the light exposure device according to any one of claims 1 to 11 that exposes the image holding member to light to form a latent image;
a developing member that develops the latent image on the image holding member;
a transfer member that transfers an image obtained with development performed by the developing member to a medium; and
a fixing member that fixes the image transferred to the medium.
